# FASCICULE DE BREVET EUROPEEN

(11) **EP 2 262 848 B1**
(45) Date de publication et mention de la délivrance du brevet: **15.08.2012**
(21) Numéro de dépôt: 09742291.9
(22) Date de dépôt: 09.04.2009
(51) Int. Cl.: C08G 77/04, C08G 77/10, C09D 183/06, G03F 7/075, C08G 77/14

(54) **PROCEDE DE PREPARATION D'UNE COMPOSITION PHOTORETICULABLE**
VERFAHREN ZUR HERSTELLUNG EINER LICHTVERNETZBAREN ZUSAMMENSETZUNG
METHOD FOR PREPARING A PHOTO-CROSSLINKABLE COMPOSITION

(30) Priorité: 11.04.2008 FR 0852452
(43) Date de publication de la demande: 22.12.2010
(73) Titulaire: Essilor International (Compagnie Générale d'Optique), 94220 Charenton-le-Pont (FR); Centre National de la Recherche Scientifique - CNRS, 75794 Paris Cedex 16 (FR)
(72) Inventeur: BALLET, Jérôme, F-94220 Charenton-le-Pont (FR); BIVER, Claudine, F-94220 Charenton-le-Pont (FR); CANO, Jean-Paul, F-94220 Charenton-le-Pont (FR); DELIANE, Florent, F-34095 Montpellier Cedex 5 (FR); ETIENNE, Pascal, F-34095 Montpellier Cedex 5 (FR); LLOSA, Marjorie, F-94220 Charenton-le-Pont (FR)
(74) Mandataire: Cabinet Plasseraud
(86) Numéro de dépôt international: PCT/FR2009/050640
(87) Numéro de publication internationale: WO 2009/136093

(56) Documents cités:
- EP-A- 1 795 550
- US-A- 5 945 172
- US-A- 6 069 259
- US-A1- 2004 017 994
- US-A1- 2004 067 450

## Description

La présente invention a pour objet une composition photoréticulable à base d'époxysilanes, un procédé de préparation d'une telle composition photoréticulable, et l'utilisation d'une telle composition pour la photolithographie.

Il est connu de la demande de brevet français FR 2 872 589, au nom de la Demanderesse, de réaliser un composant optique transparent en formant dans une couche polymère transparente, sur un support également transparent, un ensemble de cellules fermées, séparées les unes des autres, et juxtaposées parallèlement à une surface dudit composant optique. Chaque cellule est remplie avec un matériau optique approprié de sorte que l'ensemble des cellules ainsi remplies confère au composant une fonction optique voulue. La fonction optique du composant peut être par exemple une puissance optique (indice de réfraction), une protection solaire (composant absorbant la lumière UV) ou un renfort de contraste (composant polarisant).

Un tel composant optique peut être formé par exemple par photolithographie comprenant le dépôt d'une composition photosensible transparente sur un support également transparent, exposition de ladite composition photosensible selon un motif fourni par un masque (photorésist), par exemple un quadrillage rectangulaire ou hexagonal, à une lumière capable de déclencher la polymérisation et/ou la réticulation de la composition dans les zones exposées, puis la révélation du motif par élimination de la composition non réticulée au moyen d'un solvant.

Dans une telle structure, les zones photoréticulées durcies correspondent alors aux parois séparant les cellules les unes des autres.

Ces parois doivent non seulement être transparentes mais présentent avantageusement un indice de réfraction le plus proche possible des autres éléments constitutifs du composant optique, et notamment du support transparent et/ou du matériau de remplissage des cellules, afin de limiter toute perturbation optique. De telles perturbations optiques sont en effet inacceptables en particulier lorsque le composant optique est utilisé en tant qu'élément destiné à protéger ou corriger la vue, comme une lentille ophtalmique par exemple.

Le matériau transparent formant les parois qui séparent les cellules du composant optique doit en outre présenter une bonne résistance chimique et mécanique afin d'assurer l'étanchéité entre les cellules.

Les parois séparant les cellules sont avantageusement les plus fines possibles afin d'assurer un remplissage maximal de la surface du composant optique avec le matériau optique. Par ailleurs, on cherchera généralement à préparer des parois qui sont non seulement les plus fines possibles, mais également les plus hautes possibles. La hauteur des parois détermine en effet directement la profondeur des cellules, autrement dit l'épaisseur de la couche de matériau optique remplissant les cellules. La hauteur des parois dépend bien entendu directement de l'épaisseur de la couche de résine photodurcissable déposée sur le support transparent.

On peut ainsi définir un « rapport de forme » (en anglais *aspect ratio)* égal au rapport hauteur/épaisseur des parois. Ce rapport est de préférence le plus grand possible et on vise généralement des valeurs supérieures ou égales à 4 ou

5. La Demanderesse a mis au point une nouvelle méthode de préparation d'une composition photoréticulable, utilisable dans un procédé de photolithographie, qui permet d'obtenir une résine parfaitement transparente, ayant un indice de réfraction proche de celui des autres matériaux optiques transparents, présentant une bonne solidité à l'état durci, qui est à la fois suffisamment fluide pour s'étaler facilement et de façon régulière sur le support transparent et suffisamment visqueuse pour conférer à la couche déposée une épaisseur relativement importante.

Cette nouvelle méthode de préparation d'une composition est caractérisée par une combinaison d'un prépolymère « hybride » de type organominéral présentant un squelette de type silice et des fonctions latérales organiques, d'un photoamorceur de polymérisation cationique et d'un photosensibilisateur.

Le prépolymère est synthétisé à partir d'un monomère, un [(époxycycloalkyl)alkyl]-trialkoxysilane, présentant trois fonctions alkoxy qui, par hydrolyse et polycondensation dans des conditions qui laissent intactes tout ou partie des fonctions époxyde, aboutissent à un réseau tridimensionnel minéral de type silice. Ce réseau minéral dense confère à la résine totalement réticulée la dureté nécessaire et une bonne résistance chimique.

Le choix de cette famille de composés est directement lié à l'utilisation que la Demanderesse souhaite faire de la composition photoréticulable. Ces composés présentent une cinétique de polymérisation qui les rend particulièrement appropriés pour le procédé de photolithographie de la présente invention, en particulier dans l'étape d'irradiation qui peut, grâce au choix de ces monomères, être réalisée dans des conditions de temps et de température optimales aboutissant au matériau thermodurci voulu. Ces composés se caractérisent en particulier par le fait que le groupe époxy situé sur le groupe cycloalkyle résiste suffisamment à l'hydrolyse acide dans les conditions mises en oeuvre à l'étape (a) du procédé (pH compris entre 1,6 et 4, température 50 - 70 °C) tout en présentant une réactivité intéressante au moment de la photoréticulation de la composition contenant le prépolymère. Les prépolymères préparés dans la présente invention sont ainsi plus réactifs que ceux préparés à partir du 3-glycidyloxypropyltrimethoxysilane (Glymo) où le groupe époxy est porté non pas par un groupe cycloalkyle mais une chaîne alkyle linéaire. Cette réactivité plus importante permet non seulement de raccourcir de manière avantageuse l'étape de photoréticulation (qui ne prend que quelques secondes), mais permet, contrairement au 3-glycidyloxypropyltrimethoxysilane, d'obtenir les rapports de forme souhaités supérieurs à 4.

Le procédé de préparation de la composition photoréticulable de la présente invention est mené de manière à ce que la quasi-totalité, voire la totalité, des fonctions alcoxy-silane du monomère soit hydrolysée mais seule une partie des fonctions silanol obtenues soit condensée. Cette condensation partielle aboutit à un mélange d'oligomères comportant très peu de fonctions alcoxysilane résiduelles (moins de 5 %) et un grand nombre de fonctions époxyde qui ne réagiront qu'au cours de l'étape de photoréticulation amorcée par un rayonnement approprié. Le procédé de la présente invention est en effet conçu de manière à ce qu'au plus 20 à 30 % des fonctions époxyde initiales soient hydrolysées et que le prépolymère comporte encore au moins environ 70 % des groupes époxy présents au départ sur les monomères.

Le demande de brevet US 2004/0017994 décrit l'utilisation d'époxyalkyltriorganoxysilanes, tels que le 2-(3,4-époxycyclohexyléthyl)triméthoxysilane et le 3-glycidoxypropyltriéthoxysilane (Glymo), pour la préparation de guides d'ondes par photodurcissement de compositions de prépolymères. Le procédé décrit dans ce document comporte une étape d'hydrolyse acide d'une solution hydro-alcoolique du monomère à basse température (0 - 50 °C), suivie d'une réaction de condensation à haute température, c'est-à-dire à une température supérieure au point d'ébullition du solvant. Les prépolymères obtenus dans ces conditions comportent très peu de groupes époxyde. En effet, environ 90 % des fonctions époxyde initialement présentes sur les monomères sont hydrolysées au cours du procédé (voir les formules des organopolysiloxanes obtenus aux exemples 1 - 3). De tels prépolymères comportant peu de groupes époxyde nécessitent des étapes de photodurcissement relativement longues (plusieurs minutes) et ne permettent pas d'obtenir des rapports de forme élevés. L'épaisseur des couches durcies en présence d'un masque (= hauteur des zones durcies après élimination des zones non durcies) est en effet inférieure à 10 µm (voir exemples 1 - 3), alors que pour l'application envisagée dans la présente invention, il est souhaitable d'obtenir des hauteurs de l'ordre de quelques dizaines de micromètres, par exemple de 10 à 50 µm, pour des largeurs relativement faibles, de l'ordre de quelques micromètres seulement.

La présente invention a par conséquent pour objet un procédé de préparation d'une composition photoréticulable comprenant les étapes suivantes :
(a) réaction d'hydrolyse et de condensation d'un [(époxycycloalkyl)alkyl]-trialcoxysilane en solution dans un milieu organoaqueux contenant de l'eau, dans un rapport molaire initial eau/monomère compris entre 3 et 15, de préférence compris entre 8 et 12 et en particulier entre 9 et 11, et au moins un solvant miscible avec l'eau, à un pH compris entre 1,6 et 4,0, préférentiellement compris entre 1,6 et 3,0, par chauffage de la solution à une température comprise entre 50 et 70 °C pendant une durée comprise entre 180 et 350 minutes, de manière à obtenir une solution d'un prépolymère hybride organominéral dont la totalité ou quasi-totalité des groupes alcoxysilane a été hydrolysée et qui comporte en moyenne au moins 4 groupes (époxycycloalkyl)alkyle, de préférence de 4 à 10 groupes (époxycycloalkyl)alkyle par molécule,
(b) refroidissement de la composition de prépolymère polyépoxydé obtenue jusqu'à une température comprise entre 15 et 25 °C,
(c) addition à cette composition d'au moins un photoamorceur de polymérisation cationique et d'au moins un photosensibilisateur présentant un maximum d'absorption à une longueur d'onde comprise entre 300 et 420 nm, et optionnellement addition d'un tensioactif,
(d) agitation de la composition obtenue pendant une durée comprise entre 10 et 120 minutes, de préférence entre 20 et 40 minutes, à une température comprise entre 15 et 25 °C,
(e) filtration de la composition obtenue sur un filtre comportant des pores d'une taille moyenne comprise entre 1 et 5 µm, et
(f) stockage du filtrat liquide obtenu à une température inférieure à 0 °C, de préférence comprise entre -20 °C et -10 °C.

Enfin, l'invention a pour objet l'utilisation d'une telle composition dans un procédé de photolithographie et un procédé de photolithographie utilisant une telle composition.

Le monomère servant à la synthèse du prépolymère polyépoxydé photoréticulable est un [(époxycycloalkyl)alkyl]-trialcoxysilane dans lequel les deux atomes de carbone de la fonction époxy font partie du groupe cycloalkyle. Le groupe cycloalkyle est de préférence un groupe cycloalkyle en C₄₋₈, en particulier un groupe cyclohexyle. Le groupe alkyle porteur du groupe époxycycloalkyle est de préférence un groupe alkyle en C₁₋₆ linéaire ou ramifié, en particulier un groupe éthyle. Enfin, les trois groupes alcoxy, reliés directement à l'atome de silicium, sont indépendamment des groupes alcoxy en C₁₋₆ linéaire ou ramifié, de préférence des groupes méthoxy.

Le monomère est par conséquent de préférence un [(époxycycloalkyle en C₄₋₈)alkyle en C₁₋₆]-tri-(alcoxy en C₁₋₆)silane, et en particulier le 2-(3,4-époxycyclohexyl)éthyl-triméthoxysilane de formule (I), commercialisé par exemple par la société SHIN ETSU sous la dénomination KBM 303.

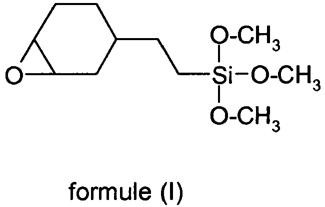

L'[(époxycycloalkyl)alkyl]-trialcoxysilane est de préférence utilisé à raison de 25 à 60 % en poids, de préférence de 30 % à 45 % en poids, rapporté au poids total du mélange réactionnel initial contenant le monomère, l'eau, le solvant et l'acide.

Le monomère est insoluble dans l'eau pure et il est par conséquent nécessaire de le solubiliser par addition d'au moins un solvant organique miscible avec l'eau. On peut en principe utiliser n'importe quel solvant organique, relativement polaire, de préférence non toxique, inerte vis-à-vis des composants du milieu réactionnel qui permet de préparer un milieu réactionnel homogène dans lequel le monomère est totalement dissous. La Demanderesse a obtenu de bons résultats avec le méthanol et l'éthanol. On utilisera de préférence de l'éthanol.

La quantité de solvant nécessaire pour dissoudre complètement l'époxysilane dépend bien entendu de la nature chimique précise du monomère et du solvant et l'homme du métier saura sans difficulté déterminer le ratio solvant/eau/monomère approprié de façon à être dans des conditions d'hydrolyse homogène.

Le pH du milieu réactionnel initial est ajusté par addition d'un acide minéral, tel que l'acide chlorhydrique, de préférence à une valeur inférieure à 3.

Dans l'étape (a) du procédé, les groupes alcoxysilane subissent une hydrolyse acide, puis les groupes hydroxyle formés réagissent les uns avec les autres, avec élimination d'une molécule d'eau, ce qui aboutit à la formation de chaînes Si-O-Si dans les trois dimensions de l'espace. Ce type de réaction est connu et utilisé couramment dans des procédés sol-gel. L'étape (a) du procédé de la présente invention est mise en oeuvre de façon à limiter la polymérisation du réseau de type silice au stade « sol », la gélification et le durcissement d'un réseau tridimensionnel n'ayant lieu qu'au cours du procédé de photolithographie. D'éventuelles particules formées au cours de l'étape (a) seront éliminées de la composition selon l'invention par l'étape de filtration (e).

Au vu de ce qui précède, on comprendra qu'il est important de limiter autant que possible la formation de particules solides, tout en laissant la polycondensation du monomère, via les groupes alcoxysilane, aller suffisamment loin pour obtenir une composition ayant une viscosité appropriée.

La réaction de l'étape (a) est de préférence mise en oeuvre à une température comprise entre 50 et 70 °C, de préférence entre 58 et 62 °C, pendant une durée comprise entre 180 et 350 minutes, de préférence entre 200 et 320 minutes, sous agitation modérée.

Après l'étape réactionnelle (a) du procédé de la présente invention, le mélange réactionnel est refroidi à température ambiante, puis on y ajoute le système de photoamorçage de la polymérisation des groupes époxyde et un optionnellement un tensioactif.

La Demanderesse a obtenu de bons résultats en utilisant un agent tensioactif fluoré tel que le produit Fluorad FC-430 commercialisé par la société 3M. Ce produit contient environ 95 à 99 % d'esters fluoroaliphatiques. Un autre agent tensioactif fluoré utilisable dans la présente invention est le produit FC4430 également commercialisé par la société 3M.

L'agent tensioactif est utilisé de préférence à raison de 0,1 à 0,5 % en poids, de préférence de 0,15 à 0,45 % en poids, rapporté à la teneur en matière sèche de ladite composition réticulable. Le tensioactif permet d'améliorer l'étalement de la résine sur le support et d'obtenir une couche déposée exempte de défauts.

La polymérisation des groupes époxyde, pendant et après l'exposition à la lumière de la composition de la présente invention, est une polymérisation cationique par ouverture de cycle. Le photoamorceur est pas conséquent un amorceur qui, lorsqu'il est soumis à un rayonnement d'une longueur d'onde appropriée, forme des cations suffisamment stables pour attaquer les groupes époxycycloalkyle du monomère. De tels photoamorceurs pour polymérisation cationique sont connus. Il s'agit en particulier de sels d'onium et l'on peut citer à titre d'exemple les sels d'iodonium et les sels de triarylsulfonium, en particulier les hexafluorophosphate d'arylsulfoniums commercialisés par la société LAMBERTI S.P.A. tel que l'Esacure 1064 et les hexafluorophosphate de iodonium commercialisé par la société CIBA, tel l'Irgacure 250. On utilisera de préférence un mélange de carbonate de propylène et d'hexafluorophosphate de (4-méthylphényl)[4-(2-méthylpropyl)phényl]-iodonium, commercialisé par exemple par la société Ciba sous la dénomination Irgacure 250.

La concentration du photoamorceur dans la composition réticulable finale est comprise entre 0,2 % et 8 % en poids, de préférence entre 0,5 % et 6 % en poids, rapportée à la teneur en matières sèches de ladite composition réticulable.

Le photoamorceur de polymérisation cationique utilisé dans la présente invention est associé à un photosensibilisateur. Les photoamorceurs pour la polymérisation cationique absorbent en général à des longueurs d'onde inadaptées aux longueurs d'onde utilisées en photolithographie. Le photosensibilisateur permet de décaler la longueur d'onde d'absorption afin de l'adapter aux équipements utilisés classiquement en photolithographie.

De tels photosensibilisateurs sont connus dans la technique. On peut citer à titre d'exemples la famille des thioxanthones et des acylphosphines, pour ces derniers on peut par exemple citer celui de la société CIBA connu sous la dénomination de Irgacure 819. La Demanderesse a obtenu de bons résultats avec un mélange de 2-isopropylthioxanthone et de 4-isopropylthioxanthone commercialisé par la société Ciba sous la dénomination Darocure ITX.

La concentration du photosensibilisateur dans la composition photoréticulable finale est de préférence comprise entre 0,3 % et 2 % en poids, de préférence entre 0,5 % et 1,8 % en poids, rapportée à la teneur en matières sèches de ladite composition réticulable.

Afin d'éviter une photoréticulation précoce indésirable de la composition de la présente invention, les étapes (c), (d), (e) et (f) du procédé de préparation ci-dessus sont réalisées à l'abri de la lumière actinique, par exemple dans des récipients opaques à la lumière actinique et/ou sous lumière inactinique.

Les compositions photoréticulables obtenues par un procédé tel que décrit ci-dessus sont généralement assez fluides, c'est-à-dire elles ont viscosité, mesurée à 20 °C à l'aide d'un rhéomètre Anton Paar MCR 300 (module de mesure CP50-2 à gradient de vitesse imposé), inférieure à 50 centipoises, de préférence comprise entre 8 et 18 centipoises. La viscosité est déterminée par extrapolation à cisaillement infini en appliquant le modèle de Bingham.

De telles viscosités faibles ne permettent pas toujours d'obtenir des couches de composition photoréticulable ayant l'épaisseur voulue. En effet, certains procédés de dépôt, tels que le dépôt par centrifugation (en anglais *spin coating),* soumettent la composition photoréticulable à des forces de cisaillement importantes qui aboutissent à des couches trop fines.

Il peut par conséquent être nécessaire de préparer des compositions photoréticulables relativement plus visqueuses permettant d'obtenir des dépôts plus épais et d'augmenter le rapport de forme des parois formées.

Par ailleurs, il peut être avantageux pour la mise en oeuvre de certains procédés de dépôt, de disposer de compositions contenant certains solvants particuliers, au lieu ou en plus de ceux utilisés dans l'étape réactionnelle.

Pour cela, on prévoit dans le procédé de préparation tel que décrit ci-dessus, successivement une étape d'évaporation partielle de la phase solvant et une étape d'ajustement de la viscosité par addition de solvant. Ces deux étapes sont insérées de préférence entre l'étape réactionnelle (a) et l'étape de refroidissement à température ambiante (étape (b)), mais on peut également envisager de les insérer entre cette dernière étape et l'addition du système de photoamorçage.

Dans un mode de réalisation particulier de la présente invention, le procédé de préparation de la composition photoréticulable comprend par conséquent en outre, entre l'étape (a) et l'étape (b), ou entre l'étape (b) et l'étape (c):
- une étape (a2) pendant laquelle la composition est soumise à une évaporation sous pression réduite, de préférence à une évaporation à une température comprise entre 25 °C et 35 °C, sous une pression réduite comprise entre 20 et 45 mbars, jusqu'à une teneur en matières sèches comprise entre 40 % et 95 %, de préférence entre 60 % et 80 %, en particulier entre 73 % et 78 % en poids et
- une étape (a3) d'addition d'au moins un solvant organique choisi parmi le 1-Méthoxy-2-propanol, la N-méthylpyrrolidone (NMP), l'acétate de l'éther méthylique de propylèneglycol (PGMEA), l'acétone, l'éthanol, le diméthyléther de propylèneglycol, de préférence le 1-Méthoxy-2-propanol (Dowanol^{®} PM), jusqu'à une teneur en matières sèches comprise entre 30 et 70 % en poids, de préférence entre 50 et 65 % en poids, et en particulier entre 55 et 62 % en poids.

Les compositions photoréticulables obtenue à l'issue d'un procédé comprenant ces deux étapes supplémentaires, ont généralement une viscosité, mesurée de la manière indiquée ci-dessus, comprise entre 250 et 650 centipoises.

Le contrôle de la viscosité de la composition et de la nature du solvant permet de garantir un dépôt régulier de la composition photoréticulable sur le support transparent, généralement en polymère synthétique. L'uniformité de l'épaisseur du dépôt est en effet la garantie d'une bonne résolution lors du procédé de photolithographie sur l'ensemble de la surface à traiter.

Le remplacement du solvant et l'augmentation de la viscosité de la composition photoréticulable peuvent également être obtenus en soumettant le mélange réactionnel à une phase d'évaporation sous vide et en ajoutant ensuite le solvant souhaité sous forme d'une solution avec le photoamorceur, le photosensibilisateur et éventuellement l'agent tensioactif.

Dans cette variante du procédé de la présente invention, les étapes (b), (c) et (d) sont donc remplacées par les étapes (b2), (c2) et (d2) suivantes :
(b2) évaporation de la phase solvant du mélange réactionnel de l'étape (a) pendant 120 à 300 minutes, sous pression réduite comprise entre 20 et 30 mbars, à une température comprise entre 45 °C et 65 °C, jusqu'à une teneur en matières sèches comprise entre 60 % et 85 %, en particulier entre 73 % et 78 % en poids,
(c2) préparation, à température ambiante et sous agitation, d'une solution homogène d'au moins un photoamorceur, d'au moins un photosensibilisateur, éventuellement d'au moins un agent tensioactif, dans un solvant choisi parmi le 1 - Méthoxy-2-propanol, la N-méthylpyrrolidone (NMP), l'acétate de l'éther méthylique de propylèneglycol (PGMEA), l'acétone, l'éthanol, le diméthyléther de propylèneglycol, de préférence le 1-Méthoxy-2-propanol;
(d2) mélange à température ambiante de la composition concentrée obtenue à l'étape (b2) avec la solution homogène obtenue à l'étape (c2) par agitation pendant une durée comprise entre 30 et 60 minutes, le rapport de mélange étant tel que la composition obtenue présente une teneur en matières sèches comprise entre 40 et 70 % en poids, de préférence proche de 60 % en poids.

Les compositions photoréticulables obtenues à l'issue de ce procédé de préparation ont également une viscosité, mesurée de la manière indiquée ci-dessus, comprise entre 250 et 650 centipoises.

Comme indiquée précédemment, la composition photoréticulable de la présente invention peut être utilisée dans un procédé de photolithographie de fabrication de composants optiques transparents tels que décrits dans la demande FR 2 872 589. Elle est alors utilisée en tant que résine photosensible négative, c'est-à-dire dans les zones exposées à la lumière la composition polymérise et réticule aboutissant à la formation d'un matériau solide, alors que dans les zones non exposées à la lumière la composition reste liquide et soluble et est éliminée lors de la phase de révélation (lavage par un solvant approprié).

Cette technique de photolithographie nécessite, de manière connue, un masque en deux dimensions (photorésist) qui permet l'exposition sélective de certaines zones de la couche de composition photoréticulable de la présente invention. Pour la préparation de composants optiques tels que ceux décrits dans FR 2 872 589 les zones exposées à la lumière correspondent aux futures parois séparant les cellules, alors que les zones protégées par le photorésist correspondent à la surface occupée par les cellules, ou « cuves », qui seront ultérieurement remplies par le matériau optique.

Pour un tel composant optique à microcuves, on peut définir un « facteur de remplissage » qui correspond à la proportion de la surface occupée par les cellules, ou cuves, rapportée à la surface totale du composant. Ce facteur de remplissage est de préférence au moins égal à 95 %, en particulier au moins égal à 98 %. A titre d'exemple, un facteur de remplissage de 98 % correspond, pour des cuves de forme carrée, à une largeur de paroi de 2 µm pour une largeur de cuve de 200 µm.

La composition photoréticulable de la présente invention permet, grâce à sa composition particulière, l'obtention de composants optiques transparents microstructurés tels que décrits dans FR 2 872 589, comprenant notamment des lentilles optiques tels que des lentilles ophtalmiques et des vitrages tels que des vitres du bâtiment et des vitres de véhicules de transport, avec des rapports de forme importants, supérieurs ou égaux à 5. Autrement dit, le procédé de photolithographie décrits plus en détail ci-après, utilisant la résine photoréticulable de la présente invention, permet la fabrication de parois ayant une hauteur comprise entre 10 et 50 µm, de préférence comprise entre 15 et 50 µm, et une largeur, ou épaisseur, comprise entre 1 µm et 8 µm, de préférence entre 2 µm et 5 µm.

Comme indiqué précédemment, la présente invention a également pour objet un procédé de photolithographie utilisant la composition photoréticulable décrite ci-dessus. Ce procédé de photolithographie comprend les étapes successives suivantes :
(i) dépôt d'une couche d'une composition photoréticulable telle que décrite ci-dessus sur un support, de préférence un support transparent (étape de dépôt),
(ii) exposition de certaines zones de la couche de composition photoréticulable à un rayonnement permettant d'activer le photoamorceur et/ou le photosensibilisateur et de déclencher la polymérisation cationique des fonctions époxycycloalkyle du prépolymère présent dans ladite composition photoréticulable (étape d'irradiation), et
(iii) élimination des zones non photoréticulées par immersion du support portant la composition partiellement photoréticulée dans un solvant de la composition photoréticulable (étape de révélation).

Le support transparent recevant la couche de composition photoréticulable est de préférence en matière plastique, c'est-à-dire en un polymère synthétique. On peut citer à titre d'exemple non limitatif le poly(éthylène téréphtalate) (PET). Le dépôt peut se faire par n'importe quelle technique de dépôt appropriée telles que le dépôt par immersion, par pulvérisation, à la barre *(bar coating)* ou par centrifugation (*spin coating*)*.* On préfère en particulier le dépôt par centrifugation.

L'étape d'irradiation se fait de préférence avec une lumière présentant des raies d'émission ayant une longueur d'onde comprise entre 240 et 420 nm, de préférence avec une lumière d'une lampe à mercure ou xénon-mercure présentant une raie d'émission à 365 nm. L'irradiation de la composition photoréticulable se fait de préférence avec une dose supérieure ou égale à 100 mJ/cm².

Le solvant utilisé, dans l'étape de révélation, pour l'élimination de la composition non réticulée, peut être n'importe quel solvant qui est un bon solvant de la composition non réticulée mais laisse intactes les parties réticulées. On peut citer à titre d'exemple l'acétone ou l'isopropanol que l'on utilisera de préférence à température ambiante.

De préférence, et de manière connue, les étapes de dépôt, d'irradiation et de révélation ci-dessus sont suivies d'étapes de recuit.

Ainsi, l'étape (i) est généralement suivie d'une étape de « pré-recuit » (en anglais *soft bake*)*,* de préférence à une température comprise entre 40 et 100 °C, pendant une durée comprise entre 2 et 30 minutes. Ce pré-recuit sert principalement à évaporer au moins une partie du solvant.

L'étape (ii) d'exposition à la lumière est de préférence suivie d'une étape de « recuit de réticulation » (en anglais *post-exposure bake),* de préférence à une température comprise entre 20 °C et 85 °C, en particulier entre 50 °C et 80 °C, pendant une durée comprise entre 5 et 30 minutes. Ce deuxième recuit a pour fonction de favoriser la polymérisation en chaîne des fonctions époxy et la réticulation de la résine photosensible.

Enfin, l'étape (iii) de révélation est suivie d'une étape de « recuit final » (en anglais *hard bake),* de préférence à une température comprise entre 100 °C et 130 °C, en particulier entre 110 °C et 125 °C, pendant une durée comprise entre 30 et 180 minutes, de préférence entre 50 et 120 minutes. Cette étape sert à parachever la condensation des fonctions silanol et la polymérisation en chaîne des fonctions époxy résiduelles et confère à la résine finale sa résistance chimique et mécanique.

Ces différentes étapes du procédé de photolithographie seront adaptées en fonction de la géométrie du réseau de microstructures que l'on souhaite obtenir, en tenant compte notamment des paramètres de hauteur et d'épaisseur des parois, ainsi que de la distance séparant les parois les unes des autres. Les paramètres de chaque étape du procédé de photolithographie seront également adaptés aux équipements utilisés. De telles adaptations sont bien connues de l'homme du métier.

### Exemple 1

### Préparation d'une composition photoréticulable

On introduit dans un réacteur en verre d'une capacité de 5 litres, muni d'une double enveloppe et d'un système d'agitation, 1804 g (7,3 moles) de 2-(3,4-époxycyclohexyl)éthyl-triméthoxysilane (EETMOS, masse molaire 246 g.mol⁻¹) fourni par la société Shin Etsu et 557 g d'éthanol absolu. La solution est agitée à une vitesse de rotation de 700 tours/minute. On introduit alors, sous agitation et sur une durée de 10 minutes, un mélange préalablement préparé de 557 g d'éthanol absolu et de 1320 g d'une solution aqueuse d'acide chlorhydrique à 0,1 N (environ 73 moles d'eau) de manière à obtenir une solution réactionnelle avec un rapport molaire eau/monomère initial environ égal à 10. La température à l'intérieur du réacteur est alors amenée à 60 °C. Le milieu réactionnel est maintenu pendant une durée de 5 heures à cette température et sous une agitation de 200 tours/minute. Au bout de 5 heures, on refroidit le milieu réactionnel à température ambiante en faisant circuler un fluide froid dans la double enveloppe du réacteur. Ce retour à température ambiante se fait sur une durée de 90 minutes. La quantité de solution recueillie est de 4220 g. Son extrait sec est de 32,5 % et sa viscosité à 20 °C égale à 9,78 cP. Cette solution ne contient plus de monomère initial non hydrolysé.

Une partie de la solution ainsi obtenue est concentrée sous vide dans un évaporateur rotatif. Pour cela, 719,8 g de la solution sont introduits dans un ballon piriforme de 2 litres. Ce ballon est installé sur l'évaporateur rotatif. L'évaporation est réalisée en plongeant le ballon dans un bain thermostaté à une température de 30 °C et en le maintenant sous rotation lente. La pression est réduite progressivement jusqu'à 25 mbars en prenant soin de maîtriser l'ébullition du liquide. On arrête l'évaporation au bout d'environ 2 heures lorsque l'extrait sec de la solution a atteint une valeur de 73 %. 312 g de cette solution de prépolymère concentrée sont retirés du ballon.

On introduit ensuite dans un flacon de couleur brune opaque aux UV, 3,41 g de photosensibilisateur (Darocure ITX de la société Ciba) et 58,55 g de 1-Méthoxy-2-propanol (Dowanol PM). On agite le mélange pendant 5 minutes à 900 tours/minute afin de solubiliser la totalité du photosensibilisateur. On introduit ensuite dans ce mélange 10,3 g de photoamorceur (Irgacure 250 de la société Ciba) et 0,82 g de tensioactif fluoré (FC430 de la société 3M). On agite de nouveau pendant 5 minutes. On introduit ensuite dans ce mélange, sous agitation, 270 g de la solution concentrée obtenue après évaporation, présentant un extrait sec de 73 %. L'ajout se fait par petites portions afin d'obtenir un mélange homogène. Lorsque la totalité de la solution de prépolymère concentrée a été ajoutée, on maintient pendant 30 minutes une agitation lente afin d'éviter la formation de bulles. La composition obtenue est ensuite filtrée sur un filtre Sartopure 300 PP2 de porosité 3 µm à l'aide d'une pompe péristaltique. La viscosité du filtrat recueilli est de 346 cP.

Pour finir, la composition est conditionnée dans des flacons bruns, opaques aux UV, puis stockée au congélateur à une température de -18 °C.

### Exemple 2

### Procédé de photolithographie

- Etalement de la composition obtenue dans l'exemple 1 à partir d'une machine de centrifugation avec les paramètres suivants :
   o Volume de composition déposé : 5 mL
   o Vitesse de rotation : 1000 tr/min
   o Accélération : 1000 tr/min/sec
   o Durée : 30s
- Prérecuit d'évaporation des solvants (Soft bake) :
   o 10 min à 50 °C en étuve
- Insolation
   o 200 mJ/cm² à 365 nm en soft contact.
- Post recuit de réticulation (Post bake) :
   o 20 min à 80°C en étuve
- Développement :
   o Trempage dans isopropanol avec agitation durant 1 min et 30 sec
   o Rinçage à l'acétone et l'eau dionisée
- Hard Bake :
   o 3h à 110°C

Ce procédé illustré dans l'exemple 2 permet d'obtenir un réseau de microstructures comprenant des parois de 20 µm de hauteur et présentant une épaisseur de 3 µm.

## Revendications

1. Procédé de préparation d'une composition photoréticulable comprenant les étapes suivantes :
(a) réaction d'hydrolyse et de condensation d'un [(époxycycloalkyl)alkyl]-trialcoxysilane en solution dans un milieu organoaqueux contenant de l'eau, dans un rapport molaire initial eau/monomère compris entre 3 et 15, et au moins un solvant miscible avec l'eau, à un pH compris entre 1,6 et 4,0, préférentiellement compris entre 1,6 et 3,0, par chauffage de la solution à une température comprise entre 50 et 70 °C pendant une durée comprise entre 180 et 350 minutes, de manière à obtenir une solution d'un prépolymère hybride organominéral dont la totalité ou plus de 95 % des groupes alcoxysilane a été hydrolysée et qui comporte en moyenne au moins 4 groupes (époxycycloalkyl)alkyle, de préférence de 4 à 10 groupes (époxycycloalkyl)alkyle par molécule,
(b) refroidissement de la composition de prépolymère polyépoxydé obtenue jusqu'à une température comprise entre 15 et 25 °C,
(c) addition à cette composition d'au moins un photoamorceur de polymérisation cationique et d'au moins un photosensibilisateur présentant un maximum d'absorption à une longueur d'onde comprise entre 300 et 420 nm, et addition d'un tensioactif,
(d) agitation de la composition obtenue pendant une durée comprise entre 10 et 120 minutes, de préférence entre 20 et 40 minutes, à une température comprise entre 15 et 25 °C,
(e) filtration de la composition obtenue sur un filtre comportant des pores d'une taille moyenne comprise entre 1 µm et 5 µm, et
(f) stockage du filtrat liquide obtenu à une température inférieure à 0 °C, de préférence comprise entre -20 °C et -10 °C.

2. Procédé de préparation selon la revendication 1, **caractérisé par le fait que** l'[(époxycycloalkyl)alkyl]-trialcoxysilane est un [(époxycycloalkyle en C₄₋₈)alkyle en C₁₋₆]-tri-(alcoxy en C₁₋₆)silane, de préférence le 2-(3,4-époxycyclohexyl)éthyl-triméthoxysilane.

3. Procédé de préparation selon la revendication 1 ou 2, **caractérisé par le fait que** la concentration de [(époxycycloalkyl)alkyl]-trialcoxysilane dans le milieu réactionnel de l'étape (a) est comprise entre 25 et 60 % en poids, de préférence entre 30 % et 45 % en poids.

4. Procédé de préparation selon l'une quelconque des revendications précédentes, **caractérisé par le fait que** la réaction d'hydrolyse-condensation de l'étape (a) est mise en oeuvre à une température comprise entre 55 et 65 °C, de préférence entre 58 et 62 °C, pendant une durée comprise entre 200 et 320 minutes.

5. Procédé de préparation selon l'une quelconque des revendications précédentes, **caractérisé par le fait qu'**à l'étape (c) un agent tensioactif est ajouté, de préférence un agent tensioactif fluoré.

6. Procédé de préparation selon la revendication 5, **caractérisé par le fait que** la concentration de l'agent tensioactif dans la composition photoréticulable finale est comprise entre 0,1 et 0,5 % en poids, de préférence entre 0,15 et 0,45 % en poids, rapportée à la teneur en matières sèches de ladite composition réticulable.

7. Procédé de préparation selon l'une quelconque des revendications précédentes, **caractérisé par le fait que** le photosensibilisateur est choisi parmi la famille des thioxanthones et des acylphosphines, et est de préférence un mélange de 2-isopropylthioxanthone et de 4-isopropylthioxanthone.

8. Procédé de préparation selon l'une quelconque des revendications précédentes, **caractérisé par le fait que** la concentration du photosensibilisateur dans la composition photoréticulable finale est comprise entre 0,3 % et 2 % en poids, de préférence entre 0,5 % et 1,8 % en poids, rapportée à la teneur en matières sèches de ladite composition réticulable.

9. Procédé de préparation selon l'une quelconque des revendications précédentes, **caractérisé par le fait que** le photoamorceur de polymérisation cationique est choisi parmi les sels d'iodonium et les sels de triarylsulfonium, en particulier les hexafluorophosphate d'arylsulfoniums, et est de préférence un mélange de carbonate de propylène et d'hexafluorophosphate de (4-méthylphényl)[4-(2-méthylpropyl)phényl]-iodonium.

10. Procédé de préparation selon l'une quelconque des revendications précédentes, **caractérisé par le fait que** la concentration du photoamorceur dans la composition réticulable finale est comprise entre 0,2 % et 8,0 % en poids, de préférence entre 0,5 % et 6 % en poids, rapportée à la teneur en matières sèches de ladite composition réticulable.

11. Procédé de préparation selon l'une quelconque des revendications précédentes, **caractérisé par le fait que** le solvant utilisé à l'étape (a) est choisi parmi l'éthanol et le méthanol, et est de préférence l'éthanol.

12. Procédé de préparation selon l'une quelconque des revendications précédentes, **caractérisé par le fait que** le pH du milieu réactionnel est inférieur à 3, ce pH étant ajusté de préférence par addition d'acide chlorhydrique.

13. Procédé de préparation selon l'une quelconque des revendications 1 à 12, **caractérisé par le fait qu'**il comprend en outre, entre l'étape (a) et l'étape (b), ou entre l'étape (b) et l'étape (c),
- une étape (a2) pendant laquelle la composition est soumise à une évaporation sous pression réduite, de préférence à une évaporation à une température comprise entre 25 °C et 35 °C, sous une pression réduite comprise entre 20 et 45 mbars, jusqu'à une teneur en matières sèches comprise entre 40 % et 95 %, de préférence entre 60 % et 80 %, en particulier entre 73 % et 78 % en poids et
- une étape (a3) d'addition d'au moins un solvant organique choisi parmi le 1-méthoxy-2-propanol, la N-méthylpyrrolidone (NMP), l'acétate de l'éther méthylique de propylèneglycol (PGMEA), l'acétone, l'éthanol, le diméthyléther de propylèneglycol, de préférence le 1-méthoxy-2-propanol, jusqu'à une teneur en matières sèches comprise entre 30 et 70 % en poids, de préférence entre 50 et 65 % en poids, et en particulier entre 55 et 62 % en poids.

14. Procédé selon l'une quelconque des revendications précédentes, **caractérisé par le fait que** les étapes (b), (c) et (d) sont remplacées par les étapes (b2), (c2) et (d2) suivantes :
(b2) évaporation de la phase solvant du mélange réactionnel de l'étape (a) pendant 120 à 300 minutes, sous pression réduite comprise entre 20 et 30 mbars, à une température comprise entre 45 °C et 65 °C, jusqu'à une teneur en matières sèches comprise entre 60 % et 85 %, en particulier entre 73 % et 78 % en poids,
(c2) préparation, à température ambiante et sous agitation, d'une solution homogène d'au moins un photoamorceur, d'au moins un photosensibilisateur, éventuellement d'au moins un agent tensioactif, dans un solvant choisi parmi le 1-méthoxy-2-propanol, la N-méthylpyrrolidone (NMP), l'acétate de l'éther méthylique de propylèneglycol (PGMEA), l'acétone, l'éthanol, le diméthyléther de propylèneglycol, de préférence le 1-méthoxy-2-propanol,
(d2) mélange à température ambiante de la composition concentrée obtenue à l'étape (b2) avec la solution homogène obtenue à l'étape (c2) par agitation pendant une durée comprise entre 30 et 60 minutes, le rapport de mélange étant tel que la composition obtenue présente une teneur en matières sèches comprise entre 40 et 70 % en poids, de préférence proche de 60 % en poids.

15. Utilisation d'une composition photoréticulable obtenue selon le procédé selon l'une quelconque des revendications 1 à 14 en tant que résine photosensible négative dans un procédé de photolithographie.

16. Procédé de photolithographie comprenant
(i) le dépôt d'une couche d'une composition photoréticulable obtenue selon le procédé selon l'une quelconque des revendications 1 à 14 sur un support, de préférence un support transparent (dépôt),
(ii) l'exposition de certaines zones de la couche de composition photoréticulable à un rayonnement permettant d'activer le photoamorceur et/ou le photosensibilisateur et de déclencher la polymérisation cationique des fonctions époxycycloalkyle du prépolymère présent dans ladite composition photoréticulable (irradiation),
(iii) élimination des zones non photoréticulées par immersion du support portant la composition partiellement photoréticulée dans un solvant de la composition photoréticulable (révélation).

17. Procédé selon la revendication 16, **caractérisé par le fait que** l'étape (i) est suivie d'une étape de pré-recuit, de préférence à une température comprise entre 40 et 100 °C, pendant une durée comprise entre 2 et 30 minutes, et/ou **par le fait que** l'étape (ii) d'exposition à la lumière est suivie d'une étape de recuit de réticulation de préférence à une température comprise entre 20 °C et 85 °C, en particulier entre 50 °C et 80 °C, pendant une durée comprise entre 5 et 30 minutes, et/ou **par le fait que** l'étape (iii) de révélation est suivie d'une étape de recuit final, de préférence à une température comprise entre 100 °C et 130 °C, de préférence entre 110 °C et 125 °C, pendant durée comprise entre 30 et 180 minutes, de préférence entre 50 et 120 minutes.

18. Procédé selon l'une des revendications 16 et 17, **caractérisé par le fait que** l'irradiation se fait avec une lumière présentant des raies d'émission ayant une longueur d'onde comprise entre 240 et 420 nm, de préférence avec une lumière d'une lampe à mercure ou xénon-mercure présentant une raie d'émission à 365 nm, avec une dose supérieure ou égale à 100 mJ/cm².

19. Utilisation d'une composition photoréticulable obtenue selon le procédé selon l'une des revendications 1 à 14 dans un procédé de photolithographie selon l'une des revendications 16 à 18 pour la réalisation de composants optiques transparents microstructurés, comprenant notamment des lentilles optiques telles que des lentilles ophtalmiques, ou des vitrages tels que des vitres du bâtiment ou des vitres de véhicules de transport.

## Claims

1. A method for preparing a photocrosslinkable composition, comprising the following steps:
(a) a reaction for hydrolysis and condensation of an [(epoxycycloalkyl)alkyl]trialkoxysilane in solution in an organoaqueous medium containing water, in a water/monomer initial molar ratio of between 3 and 15, and at least one water-miscible solvent, at a pH of between 1.6 and 4.0, preferably between 1.6 and 3.0, by heating the solution at a temperature of between 50 and 70°C for a period of between 180 and 350 minutes, so as to obtain a solution of an organomineral hybrid prepolymer, in which all or more than 95 % of the alkoxysilane groups have been hydrolyzed, and which comprises on average at least 4 (epoxycycloalkyl)alkyl groups, preferably from 4 to 10 (epoxycycloalkyl)alkyl groups, per molecule,
(b) cooling the polyepoxide prepolymer composition obtained to a temperature of between 15 and 25°C,
(c) adding to this composition at least one cationic polymerization photoinitiator and at least one photosensitizer having a maximum absorption at a wavelength of between 300 and 420 nm, and adding a surfactant,
(d) stirring the composition obtained for a period of between 10 and 120 minutes, preferably between 20 and 40 minutes, at a temperature of between 15 and 25°C,
(e) filtering the composition obtained through a filter comprising pores with an average size of between 1 µm and 5 µm, and
(f) storing the liquid filtrate obtained at a temperature below 0°C, preferably between -20°C and -10°C.

2. The preparation method as claimed in claim 1, **characterized in that** the [(epoxycycloalkyl)alkyl]trialkoxysilane is a [(epoxy(C₄₋₈ cycloalkyl))C₁₋₆ alkyl]tri(C₁₋₆ alkoxy)silane, preferably 2-(3-4-epoxycyclohexyl)ethyltrimethoxysilane.

3. The preparation method as claimed in claim 1 or 2, **characterized in that** the concentration of [(epoxycycloalkyl)alkyl]trialkoxysilane in the reaction medium of step (a) is between 25% and 60% by weight, preferably between 30% and 45% by weight.

4. The preparation method as claimed in any one of the preceding claims, **characterized in that** the hydrolysis-condensation reaction of step (a) is carried out at a temperature of between 55 and 65°C, preferably between 58 and 62°C, for a period of between 200 and 320 minutes.

5. The preparation method as claimed in any one of the preceding claims, **characterized in that**, in step (c), a surfactant is added, preferably a fluorinated surfactant.

6. The preparation method as claimed in claim 5, **characterized in that** the concentration of the surfactant in the final photocrosslinkable composition is between 0.1% and 0.5% by weight, preferably between 0.15% and 0.45% by weight, relative to the solids content of said crosslinkable composition.

7. The preparation method as claimed in any one of the preceding claims, **characterized in that** the photosensitizer is chosen from the family of thioxanthones and of acylphosphines, and is preferably a mixture of 2-isopropylthioxanthone and 4-isopropylthioxanthone.

8. The preparation method as claimed in any one of the preceding claims, **characterized in that** the concentration of the photosensitizer in the final photocrosslinkable composition is between 0.3% and 2% by weight, preferably between 0.5% and 1.8% by weight, relative to the solids content of said crosslinkable composition.

9. The preparation method as claimed in any one of the preceding claims, **characterized in that** the cationic polymerization photoinitiator is chosen from iodonium salts and triarylsulfonium salts, in particular arylsulfonium hexafluorophosphates, and is preferably a mixture of propylene carbonate and (4-methylphenyl)[4-(2-methylpropyl)phenyl]iodonium hexafluorophosphate.

10. The preparation method as claimed in any one of the preceding claims, **characterized in that** the concentration of the photoinitiator in the final crosslinkable composition is between 0.2% and 8.0% by weight, preferably between 0.5% and 6% by weight, relative to the solids content of said crosslinkable composition.

11. The preparation method as claimed in any one of the preceding claims, **characterized in that** the solvent used in step (a) is chosen from ethanol and methanol, and is preferably ethanol.

12. The preparation method as claimed in any one of the preceding claims, **characterized in that** the pH of the reaction medium is less than 3, this pH being adjusted preferably by adding hydrochloric acid.

13. The preparation method as claimed in any one of claims 1 to 12, **characterized in that** it also comprises, between step (a) and step (b), or between step (b) and step (c),
- a step (a2) during which the composition is subjected to evaporation under reduced pressure, preferably to evaporation at a temperature of between 25°C and 35°C, under a reduced pressure of between 20 and 45 mbar, until a solids content of between 40% and 95%, preferably between 60% and 80%, in particular between 73% and 78% by weight, is obtained, and
- a step (a3) of adding at least one organic solvent chosen from 1-methoxy-2-propanol, N-methylpyrrolidone (NMP), propylene glycol methyl ether acetate (PGMEA), acetone, ethanol and propylene glycol dimethyl ether, preferably 1-methoxy-2-propanol, until a solids content of between 30% and 70% by weight, preferably between 50% and 65% by weight, and in particular between 55% and 62% by weight, is obtained.

14. The method as claimed in any one of the preceding claims, **characterized in that** steps (b), (c) and (d) are replaced with the following steps (b2), (c2) and (d2):
(b2) evaporating the solvent phase of the reaction mixture of step (a) for 120 to 300 minutes, under a reduced pressure of between 20 and 30 mbar, at a temperature of between 45°C and 65°C, until a solids content of between 60% and 85%, in particular between 73% and 78% by weight, is obtained,
(c2) preparing, at ambient temperature and with stirring, a homogeneous solution of at least one photoinitiator, at least one photosensitizer and, optionally, at least one surfactant, in a solvent chosen from 1-methoxy-2-propanol, N-methylpyrrolidone (NMP), propylene glycol methyl ether acetate (PGMEA), acetone, ethanol and propylene glycol dimethyl ether, preferably 1-methoxy-2-propanol;
(d2) mixing, at ambient temperature, the concentrated composition obtained in step (b2) with the homogeneous solution obtained in step (c2) by stirring for a period of between 30 and 60 minutes, the mixing ratio being such that the composition obtained has a solids content of between 40% and 70% by weight, preferably close to 60% by weight.

15. The use of a photocrosslinkable composition obtained by the process as claimed in any one of claims 1 to 14, as a negative photosensitive resin in a photolithography process.

16. A photolithography process, comprising:
(i) coating a layer of a photocrosslinkable composition obtained by the process as claimed in any one of claims 1 to 14 onto a support, preferably a transparent support (coating),
(ii) exposing certain areas of the layer of photocrosslinkable composition to radiation which makes it possible to activate the photoinitiator and/or the photosensitizer and to trigger the cationic polymerization of the epoxycycloalkyl functions of the prepolymer present in said photocrosslinkable composition (irradiation),
(iii) removing the nonphotocrosslinked areas by immersion of the support carrying the partially photocrosslinked composition in a solvent for the photocrosslinkable composition (revealing).

17. The process as claimed in claim 16, **characterized in that** step (i) is followed by a soft bake step, preferably at a temperature between 40 and 100°C, for a period of between 2 and 30 minutes, and/or in that step (ii) of exposing to light is followed by a post-exposure bake step, preferably at a temperature of between 20°C and 85°C, in particular between 50°C and 80°C, for a period of between 5 and 30 minutes, and/or **in that** revealing step (iii) is followed by a hard bake step, preferably at a temperature of between 100°C and 130°C, preferably between 110°C and 125°C, for a period of between 30 and 180 minutes, preferably between 50 and 120 minutes.

18. The process as claimed in any of claims 16 and 17, **characterized in that** the irradiation is carried out with light having emission lines which have a wavelength of between 240 and 420 nm, preferably with light from a mercury or xenon-mercury lamp having an emission line at 365 nm, with a dose of greater than or equal to 100 mJ/cm².

19. The use of a photocrosslinkable composition obtained by the process as claimed in any one of claims 1 to 14, in a photolithography process as claimed in any one of claims 16 to 18, for preparing microstructured transparent optical components, comprising, in particular, optical lenses, such as ophthalmic lenses, or windows such as window panes for buildings or windows for transportation vehicles.

## Patentansprüche

1. Verfahren zur Herstellung einer lichtvernetzbaren bzw. photovernetzbaren Zusammensetzung, umfassend die folgenden Schritte:
(a) Hydrolyse- und Kondensationsreaktion eines [(Epoxycycloalkyl)alkyl]trialkoxysilans in Lösung in einem wasserenthaltenden organisch-wässrigen Medium, mit einem anfänglichen molaren Verhältnis von Wasser/Monomer, umfassend zwischen 3 und 15, und mindestens einem mit Wasser mischbaren Lösungsmittel, bei einem pH-Wert, umfassend zwischen 1,6 und 4,0, vorzugsweise umfassend zwischen 1,6 und 3,0, durch Erhitzen der Lösung bei einer Temperatur, umfassend zwischen 50 und 70 °C, für eine Zeitdauer, umfassend zwischen 180 und 350 Minuten, um eine Lösung eines Organomineralhybridpräpolymers zu erhalten, von welchem alle oder mehr als 95 % der Alkoxysilangruppen hydrolysiert worden sind und das durchschnittlich mindestens 4 (Epoxycycloalkyl)alkyl-Gruppen, bevorzugt 4 bis 10 (Epoxycycloalkyl)alkylGruppen pro Molekül trägt;
(b) Abkühlen der erhaltenen polyepoxydierten Präpolymerzusammensetzung bis auf eine Temperatur, umfassend zwischen 15 und 25 °C,
(c) Zugabe mindestens eines Photoreaktionstarters der kationischen Polymerisation und mindestens eines Photosensibilisierungsmittels mit einem Absorptionsmaximum bei einer Wellenlänge, umfassend zwischen 300 und 420 nm, und Zugabe eines Tensids,
(d) Rühren der erhaltenen Zusammensetzung für eine Zeitdauer, umfassend zwischen 10 und 120 Minuten, vorzugsweise zwischen 20 und 40 Minuten, bei einer Temperatur, umfassend zwischen 15 und 25 °C,
(e) Filtrieren der erhaltenen Zusammensetzung über ein Filter mit Poren mit einem mittleren Durchmesser, umfassend zwischen 1 µm und 5 µm, und
(f) Aufbewahren des erhaltenen flüssigen Filtrats bei einer Temperatur unter 0 °C, vorzugsweise zwischen -20 °C und -10 °C.

2. Herstellungsverfahren nach Anspruch 1, **dadurch gekennzeichnet, dass** das [(Epoxycycloalkyl)alkyl]trialkoxysilan ein [(Epoxy-C₄₋₈-cycloalkyl)C₁₋₆-alkyl)]-tri-(C₁₋₆-alkoxy)silan, vorzugsweise 2-(3,4-Epoxycyclohexyl)etyl-trimethoxysilan, ist.

3. Herstellungsverfahren nach Anspruch 1 oder 2, **dadurch gekennzeichnet, dass** die Konzentration des [(Epoxycycloalkyl)alkyl]trialkoxysilans in dem Reaktionsmedium von Schritt (a) zwischen 25 Gew.-% und 60 Gew.-%, vorzugsweise zwischen 30 Gew.-% und 45 Gew.-% ist.

4. Herstellungsverfahren nach einem der vorhergehenden Ansprüche, **dadurch gekennzeichnet, dass** die Hydrolyse-Kondensations-Reaktion von Schritt (a) bei einer Temperatur, umfassend zwischen 55 und 65 °C, vorzugsweise zwischen 58 und 62 °C, während einer Zeitdauer von zwischen 200 und 320 Minuten erfolgt.

5. Herstellungsverfahren nach einem der vorhergehenden Ansprüche, **dadurch gekennzeichnet, dass** in Schritt (c) ein Tensid zugegeben wird, vorzugsweise ein fluoriertes Tensid.

6. Herstellungsverfahren nach Anspruch 5, **dadurch gekennzeichnet**, das die Konzentration des Tensids in der fertigen lichtvernetzbaren Zusammensetzung zwischen 0,1 und 0,5 Gew.-%, vorzugsweise zwischen 0,15 und 0,45 Gew.-% umfasst, bezogen auf den Trockengehalt der vernetzbaren Zusammensetzung.

7. Herstellungsverfahren nach einem der vorhergehenden Ansprüche, **dadurch gekennzeichnet, dass** der Photosensibilisator ausgewählt wird aus der Familie der Thioxanthone und der Acylphosphine, und bevorzugt ein Gemisch aus 2-Isopropylthioxanthon und 4-Isopropylthioxanthon ist.

8. Herstellungsverfahren nach einem der vorhergehenden Ansprüche, **dadurch gekennzeichnet, dass** die Konzentration des Photosensibilisators in der fertigen lichtvernetzbaren Zusammensetzung zwischen 0,3 Gew.-% und 2 Gew.-%, vorzugsweise zwischen 0,5 Gew.-% und 1,8 Gew.-%, bezogen auf das Trockengewicht der vernetzbaren Zusammensetzung, umfasst.

9. Herstellungsverfahren nach einem der vorhergehenden Ansprüche, **dadurch gekennzeichnet, dass** der Photoreaktionsstarter der kationischen Polymerisation ausgewählt wird aus lodsalzen und Triarylsulfoniumsalzen, insbesondere den Arylsulfoniumhexafluorphosphaten, und bevorzugt einem Gemisch aus Propylencarbonat und (4-Methylphenyl)[4-(2-methylpropyl)phenyl]iodonium-hexafluorphosphat.

10. Herstellungsverfahren nach einem der vorhergehenden Ansprüche, **dadurch gekennzeichnet, dass** die Konzentration des Photoreaktionsstarters in der fertigen vernetzbaren Zusammensetzung zwischen 0,2 Gew.-% und 8 Gew.-%, vorzugsweise zwischen 0,5 Gew.-% und 6 Gew.-%, bezogen auf das Trockengewicht der vernetzbaren Zusammensetzung, umfasst.

11. Herstellungsverfahren nach einem der vorhergehenden Ansprüche, **dadurch gekennzeichnet, dass** das in Schritt (a) verwendete Lösungsmittel ausgewählt wird aus Ethanol und Methanol und bevorzugt Ethanol ist.

12. Herstellungsverfahren nach einem der vorhergehenden Ansprüche, **dadurch gekennzeichnet, dass** der pH-Wert des Reaktionsmediums unter 3 ist, wobei dieser pH-Wert bevorzugt durch die Zugabe von Salzsäure eingestellt wird.

13. Herstellungsverfahren nach einem der Ansprüche 1 bis 12, **dadurch gekennzeichnet, dass** es zudem zwischen Schritt (a) und Schritt (b) oder zwischen Sc ritt (b) und Schritt (c) umfasst:
- einen Schritt (a2), während welchem die Zusammensetzung einer Verdampfung bei reduziertem Druck unterzogen wird, vorzugsweise einer Verdampfung bei einer Temperatur, umfassend den Bereich zwischen 25 °C und 35 °C, bei einem reduzierten Druck, umfassend zwischen 20 und 45 mbar, bis zu einem Trockensubstanzgehalt, umfassend zwischen 40 Gew.-% und 45 Gew.-%, vorzugsweise zwischen 60 Gew.-% und 80 Gew.-%, insbesondere zwischen 73 Gew.-% und 78 Gew.-%, und
- einen Schritt (a3) der Zugabe mindestens eines organischen Lösungsmittels, ausgewählt aus 1-Methoxy-2-propanol, N-Methylpyrrolidon (NMP), Propylenglykolmethyletheracetat (PGMEA), Aceton, Ethanol, Propylenglykoldimethylether, vorzugsweise 1-Methoxy-2-propanol, bis zu einem Trockensubstanzgehalt, umfassend zwischen 30 Gew.-% und 70 Gew.-%, vorzugsweise zwischen 50 Gew.-% und 65 Gew.-%, insbesondere zwischen 55 Gew.-% und 62 Gew.-%.

14. Verfahren nach einem der vorhergehenden Ansprüche, **dadurch gekennzeichnet, dass** die Schritte (b), (c) und (d) durch die folgenden Schritte (b2), (c2) und (d2) ersetzt werden:
(b2) Verdampfen der Lösungsmittelphase des Reaktionsgemischs von Schritt (a) während 120 bis 300 Minuten, unter reduziertem Druck zwischen 20 und 30 mbar, bei einer Temperatur zwischen 45 °C und 65 °C, bis zu einem Trockensubstanzgehalt, umfassend zwischen 60 Gew.-% und 85 Gew.-%, insbesondere zwischen 73 Gew.-% und 78 Gew.-%.
(c2) Herstellen einer homogenen Lösung aus mindestens einem Photoreaktionsstarter, mindestens einem Photosensibilisator, gegebenenfalls mindestens einem Tensid bei Raumtemperatur und unter Rühren, in einem Lösungsmittel, ausgewählt aus 1-Methoxy-2-propanol, N-Methylpyrrolidon (NMP), Propylenglykolmethyletheracetat (PGMEA), Aceton, Ethanol, Propylenglykoldimethylether, vorzugsweise 1-Methoxy-2-propanol,
(d2) Mischen der in Schritt (b2) erhaltenen konzentrierten Zusammensetzung mit einer in Schritt (c2) erhaltenen homogenen Lösung durch Rühren bei Raumtemperatur für eine Zeitdauer, umfassend zwischen 30 und 60 Minuten, wobei das Mischungsverhältnis so ist, dass das erhaltene Gemisch einen Trockensubstanzgehalt aufweist, umfassend zwischen 40 Gew.-% und 70 Gew.-%, vorzugsweise nahe 60 Gew.-%.

15. Verwendung einer lichtvernetzbaren Zusammensetzung, erhalten nach einem der Ansprüche 1 bis 14, als Negativ-Photoresist in einem Photolithographieverfahren.

16. Photolithographieverfahren, umfassend
(i) Aufbringen einer Schicht einer lichtvernetzbaren Zusammensetzung, erhalten nach einem der Ansprüche 1 bis 14, auf einem Träger, vorzugsweise einem transparenten Träger (Aufbringung)
(ii) Aussetzen bestimmter Zonen der Schicht aus lichtvernetzbarer Zusammensetzung einer Strahlung, die es erlaubt den Photoreaktionsstarter und/oder den Photosensibilisator zu aktivieren und die kationische Polymerisation von Epoxycycloalkylfunktionen des Präpolymers, das in der lichtvernetzbaren Zusammensetzung vorliegt, auszulösen (Bestrahlung),
(iii) Entfernen von nichtlichtvernetzbaren Zonen durch Eintauchen des Trägers, der die teilweise lichtvernetzbare Zusammensetzung trägt, in ein Lösungsmittel der lichtvernetzbaren Zusammensetzung (Freilegung).

17. Verfahren nach Anspruch 16, **dadurch gekennzeichnet, dass** Schritt (i) von einem Vorerhitzungsschritt gefolgt wird, vorzugsweise bei einer Temperatur, umfassend zwischen 40 und 100 °C, für eine Zeitdauer zwischen 2 und 30 Minuten, und/oder dadurch, dass der Schritt des Aussetzens unter Licht (ii) von einem Vernetzungserhitzungsschritt gefolgt wird, vorzugsweise bei einer Temperatur, umfassend zwischen 20 °C und 85 °C, insbesondere zwischen 50 °C und 80 °C, für eine Zeitdauer, umfassend zwischen 5 und 30 Minuten, und/oder dadurch, dass der Freilegungsschritt (iii) von einem abschließenden Erhitzungsschritt gefolgt wird, vorzugsweise bei einer Temperatur, umfassend zwischen 100 °C und 130 °C, vorzugsweise zwischen 110 °C und 125 °C, für eine Zeitdauer zwischen 30 und 180 Minuten, vorzugsweise zwischen 50 und 120 Minuten.

18. Verfahren nach einem der Ansprüche 16 und 17, **dadurch gekennzeichnet, dass** die Bestrahlung mit einem Licht mit einer Emissionsstrahlung mit einer Wellenlänge erfolgt, umfassend zwischen 240 und 420 nm, vorzugsweise mit einem Licht einer Quecksilber- oder Xenon-Quecksilber-Lampe, mit einer Emissionsstrahlung von 365 nm, mit einer Dosis über oder gleich 100 mJ/cm².

19. Verwendung einer lichtvernetzbaren Zusammensetzung, die nach einem der Ansprüche 1 bis 14 erhalten wurde, in einem Photolithographieverfahren nach einem der Ansprüche 16 bis 18 zur Herstellung von optisch transparenten Mikrostrukturkomponenten, umfassend insbesondere optische Linsen, wie etwa ophthalmische Linsen oder Verglasungen, wie etwa Bauverglasungen oder Transportfahrzeugverglasungen.
